# EUROPEAN PATENT APPLICATION

(11) **EP 1 713 170 A2**
(43) Date of publication of application: **18.10.2006**
(21) Application number: 06007600.7
(22) Date of filing: 11.04.2006
(51) Int. Cl.: H02N 1/00

(54) **Method of production of electrodes for an electrostatic motor, electrodes for an electrostatic motor and an electrostatic motor**

(30) Priority: 13.04.2005 JP 2005115817
(71) Applicant: FANUC LTD, Minamitsuru-gun, Yamanashi 401-0597 (JP)
(72) Inventor: Odaka, SHunichi, Minamitsuru-gun Yamanashi 401-0511 (JP); Kariya, Isao, Rm. 6-303, Minamitsuru-gun Yamanashi 401-0511 (JP)
(74) Representative: Thum, Bernhard

(57) **Abstract**

A method of production of electrodes for an electrostatic motor generating electrostatic force between a facing stator and slider, including forming core electrodes on a board of at least one of the stator and the slider by patterning a conductive substance and depositing a conductive substance on the core electrodes so that the side edges become rounded. Any method selected from electroplating, electroless plating, electrostatic coating, or screen printing can be used to deposit the conductive substance on the core electrodes. The core electrodes may be patterned using non-etching means. Further, electrodes for an electrostatic motor generating an electrostatic force between a facing stator and slider provided with core electrodes patterned on the board of at least one of the stator and the slider and a conductive substance deposited on the core electrodes to form deposition layers so that the side edges become rounded.

## Description

### BACKGROUND OF THE INVENTION

### 1. Field of the Invention

The present invention relates to a method of production of electrodes for an electrostatic motor which generates electrostatic force between a facing stator and slider, electrodes for an electrostatic motor, and an electrostatic motor.

### 2. Description of the Related Art

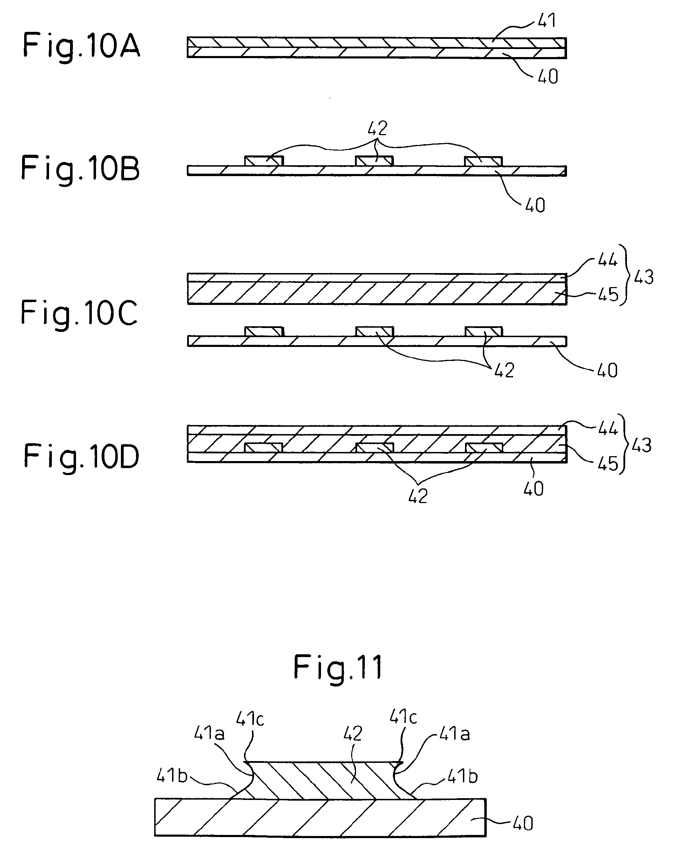

In general, electrodes for an electrostatic motor generating electrostatic force between a facing film-shaped stator and slider are formed by photolithography. In photolithography, as shown in FIG. 10A, a board 40 covered by a copper foil 41 or other conductive material is coated with a photosensitive resin, that is, a photoresist. This is irradiated with light through a mask formed into predetermined electrode patterns. The exposed parts of the photoresist are cured, while the nonexposed parts are removed by etching so as to thereby form the electrodes 42 (FIGS. 10A, 10B). The electrodes 42 are covered by a coverlay film 43 so that the individual electrodes 42 are insulated and protected (FIGS. 10C and 10D).

As an example of an electrostatic motor having electrodes formed in this way, there is the one disclosed in Japanese Examined Patent Publication No. 6-91754 (JP-B-6-91754). The disclosed electrostatic motor is provided with a stator provided with a plurality of strip-shaped electrodes and a slider placed on the stator in a contact state and not having strip-shaped electrodes, and switches the voltage supplied to the strip-shaped electrodes so as to levitate the slider and make it move linearly. A plurality of strip-shaped electrodes are formed at equal intervals on an epoxy board by etching.

Further, as an example of another related art for forming conductors by photolithography, there is the method of production of a printed coil disclosed in Japanese Unexamined Patent Publication No. 60-161605 (JP-A-60-161605).

Conductors formed by photolithography by nature are formed with groove-shaped undercuts at the side edges at the base side due to the etching proceeding isotropically. In many cases, conductors formed by photolithography are utilized as circuit parts and only have to carry electrical signals etc., so up until now undercut itself has not been focused on much at all.

However, when utilizing conductors formed by photolithography as electrodes for an electrostatic motor, if the side edges 41a at the base sides of the electrodes 42 are formed with undercuts 41b as shown in FIG. 11, the corners 41c of the electrodes 42 where the top surfaces and side faces intersect become acute angles in shape. The electric field concentrates at the sharp corners 41c. Due to this, it was learned, insulation breakdown occurs between the stator and slider.

If insulation breakdown occurs, the parts of the insulator near the electrodes are degraded due to electrodischarge, the drive voltage of the electrostatic motor is limited, the advantageous property of an electrostatic motor of the motor output being proportional to the square of the drive voltage cannot be made use of, and the motor output cannot be raised.

### SUMMARY OF THE INVENTION

An object of the present invention is to provide a method of production of electrodes for an electrostatic motor, electrodes for an electrostatic motor, and an electrostatic motor preventing or suppressing concentration of the electric field at the side edges of the electrodes, able to increase the limit voltage at which insulation breakdown occurs, and enabling higher output and longer service life.

To achieve the above object, the present invention provides a method of production of electrodes for an electrostatic motor for generating electrostatic force between a facing stator and slider, having a step of forming core electrodes on a board of at least one of the stator and the slider by patterning a conductive substance, and a step of depositing a conductive substance on the core electrodes so that the side edges become rounded.

In the above method of production of electrodes for an electrostatic motor, any one of electroplating, electroless plating, electrostatic coating, and screen printing may be used to deposit the conductive substance on the core electrodes.

Further, the core electrodes may be patterned using non-etching means. In this case, a board covered by a conductive film in advance is used and the conductive film is lasered so as to pattern the core electrodes or the core electrodes are patterned by screen printing or ink jet printing using conductive ink.

Further, the present invention provides electrodes for an electrostatic motor generating an electrostatic force between a facing stator and slider, provided with core electrodes patterned on the board of at least one of the stator and the slider and a conductive substance deposited on the core electrodes to form deposition layers so that the side edges become rounded.

Further, the present invention provides an electrostatic motor provided with a facing stator and slider and a plurality of electrodes arranged at equal intervals on at least one of the stator and the slider and supplied with voltage so as to generate electrostatic force between the stator and the slider, wherein the electrodes are electrodes for an electrostatic motor.

### BRIEF DESCRIPTION OF THE DRAWINGS

These and other objects, features, and advantages of the present invention will become clearer from the following description of the preferred embodiments given in relation to the attached drawings, in which:
FIG. 1A is a sectional view of patterning core electrodes on a board according to a first embodiment of a method of production of electrodes for an electrostatic motor of the present invention,
FIG. 1B is a sectional view of forming electroplating (deposition layers) on the core electrodes similarly according to a first embodiment of a method of production of electrodes for an electrostatic motor of the present invention,
FIG. 1C is a sectional view of superposing a coverlay film (insulator) on the electrodes similarly according to a first embodiment of a method of production of electrodes for an electrostatic motor of the present invention,
FIG. 2 is an enlarged sectional view of an electrode of FIG. 1B,
FIG. 3A is a plan view of patterning electrodes on a board according to a step of electroplating core electrodes of FIG. 1A,
FIG. 3B is a plan view of electroplating electrodes similarly according to a step of electroplating core electrodes of FIG. 1A,
FIG. 3C is a plan view of breaking the connection path with electrodes similarly according to a step of electroplating core electrodes of FIG. 1A,
FIG. 4A is a sectional view of forming an electrostatic coating on a core electrode according to a modification of the method of forming deposition layers on the core electrodes,
FIG. 4B is a sectional view of the state, after forming the electrostatic coating, heating it to melt the conductive metal, then solidifying it similarly according to a modification of the method of forming deposition layers on the core electrodes,
FIG. 5A is a perspective view of the state when superposing a screen on a board having patterned core electrodes according to another modification of the method of forming deposition layers on the core electrodes,
FIG. 5B is a sectional view of the state, after superposing a screen on a board having core electrodes, of coating conductive ink similarly according to another modification of the method of forming deposition layers on the core electrodes,
FIG. 5C is a sectional view of the state of deposition of conductive ink on core electrodes similarly according to another modification of the method of forming deposition layers on the core electrodes,
FIG. 6A is a sectional view of the state of deposition of a liquid insulator according to a modification of covering the strip-shaped electrodes by an insulator,
FIG. 6B is a sectional view of the state of finishing the solidified insulator flat according to a modification of covering the strip-shaped electrodes by an insulator,
FIG. 7 is a perspective view of a second embodiment of a method of production of electrodes for an electrostatic motor according to the present invention,
FIG. 8 is a perspective view of a third embodiment of a method of production of electrodes for an electrostatic motor according to the present invention,
FIG. 9 is a perspective view of a fourth embodiment of a method of production of electrodes for an electrostatic motor according to the present invention,
FIG. 10A is a sectional view of a conductive film-laminated board according to a step and an electrode for an electrostatic motor of an example of a conventional method of production of electrodes for an electrostatic motor,
FIG. 10B is a sectional view of patterning of electrodes similarly according to a step and electrodes for an electrostatic motor of an example of a conventional method of production of electrodes for an electrostatic motor,
FIG. 10C is a sectional view of a state of superposing a coverlay film on electrodes similarly according to a step and electrodes for an electrostatic motor of an example of a conventional method of production of electrodes for an electrostatic motor,
FIG. 10D is a sectional view of a state of the coverlay film superposed on electrodes similarly according to a step and electrodes for an electrostatic motor of an example of a conventional method of production of electrodes for an electrostatic motor, and
FIG. 11 is an enlarged sectional view of the undercuts formed at the side edges of the electrodes of FIG. 10B.

### DETAILED DESCRIPTION

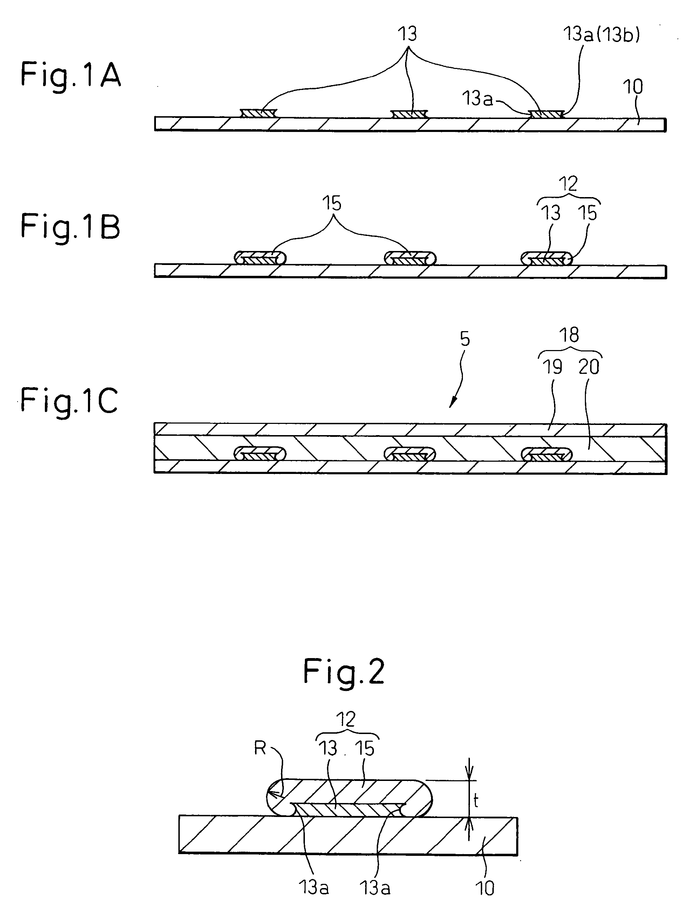

Below, preferred embodiments of the present invention will be explained in detail with reference to the drawings. FIG. 1A to FIG. 3C are explanatory views of a first embodiment of a method of production of electrodes for an electrostatic motor according to the present invention.

As shown in FIGS. 1A to 1C, the method of production of electrodes for an electrostatic motor of this embodiment includes a patterning step of forming a plurality of core electrodes 13 by predetermined patterns on a film-shaped board 10 having insulating ability and a step of depositing deposition layers 15 having conductivity on the core electrodes 13.

The present invention is not limited in the type of the electrostatic motor, that is, a linear movement type or a rotary movement type, but the electrostatic motor, not shown, of this embodiment covers a linear movement type electrostatic motor where a slider moves linearly relative to a stator. The stator 5 and the slider both form block shapes comprised of a board 10 made of a polyimide resin or epoxy resin or other insulating resin, a plurality of strip-shaped electrodes 12 formed on the board 10, and a coverlay film (insulator) 18 insulating the plurality of strip-shaped electrodes 12. The strip-shaped electrodes 12 are comprised of core electrodes 13 and deposition layers 15 electroplated over the core electrodes 13.

The strip-shaped electrodes 12 are not limited in the type of the electrostatic motor. They are strip-shaped or line-shaped both in the linear movement type and rotary movement type, but the arrangement of the plurality of strip-shaped electrodes 12 differs depending on the type of the electrostatic motor. When the electrostatic motor is a linear movement type, they are arranged in parallel, while when the electrostatic motor is a rotary movement type, they are arranged radially. The coverlay film 18 is comprised of a bonding layer 20 and an insulating layer 19. The bonding layer 19 is made to face downward used to integrally bond the film with the board 10 having the strip-shaped electrodes 12. The coverlay film 18 insulates the adjoining strip-shaped electrodes 12 from each other, insulates the strip-shaped electrodes 12 from the outside, and prevents electrodischarge and short-circuits, whereby an electrostatic force is generated between the stator 5 and slider above and below it. Here, the stator 5 and slider are substantially the same in configuration except that the strip-shaped electrodes 12 are arranged so as to intersect, so in this specification, method of production of the stator 5 side strip-shaped electrodes 12 will be explained.

The method of production of electrodes for an electrostatic motor will be explained in detail with reference to the drawings. The board 10 of the stator 5 used is, for example, one formed with rolled copper foil, electrolytic copper foil, or copper foil formed by sputtering or plating of a thickness of 17 µm or so. As shown in FIG. 1A, core electrodes 13 comprised of the copper foil are patterned on the board 10 by photolithography. Photolithography is the technique of forming interconnect conductors on a board by a semiconductor production process or FPC (flexible printed circuit) production process. This technique is used to form core electrodes 13 serving as the cores of the strip-shaped electrodes 12 in predetermined patterns on the board 10. The core electrodes 13 have groove-shaped undercuts 13b similar to the conventional electrode 42 shown in FIG. 11 at their side edges 13a.

FIG. 1B and FIG. 2, like FIG. 1A, are horizontal sectional views of the core electrodes 13 taken along the direction perpendicular to their longitudinal directions. They show the state where electroplating is used to form deposition layers 15 on the core electrodes 13. The deposition layers 15 may be formed by a metal having conductivity. For example, it is possible to use the same material, copper, as the core electrodes 13. Each deposition layer 15 is deposited isotropically so as to cover the entire outside surface of the corresponding core electrode 13 including the side edges 13a. For this reason, the undercuts 13b of the side edges 13a are completely covered by the smoothly rounded deposition layer 15. The parts of the deposition layer 15 at the undercuts 13b at the two sides 5 are built up outward and project out in an overhanging manner in a direction perpendicular to the longitudinal direction of the core electrode 13. The projecting parts of the deposition layer 15 are formed rounded with radii of curvature R of for example 1/2 or so the thickness t of the strip-shaped electrode 13 (FIG. 2). By forming the radius of curvature R to this extent of dimension, the field concentration coefficient of the electrostatic force becomes the minimum, the insulation breakdown limit voltage becomes higher, and insulation breakdown becomes hard to occur - as clear from analysis and experiments etc. Here, the "insulation breakdown limit voltage" means the upper limit of the voltage at which insulation breakdown occurs.

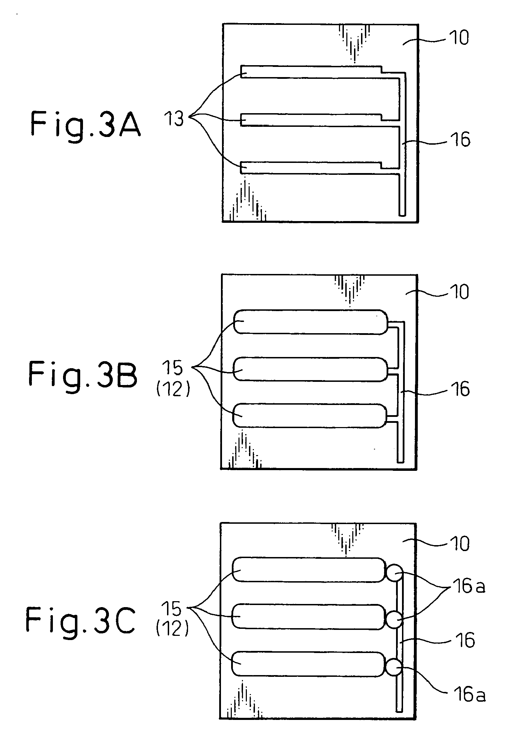

FIG. 3A to 3B show the step of electroplating the core electrodes 13. Electroplating is the method of running a direct current through an electrolyte solution including metal ions to be deposited on the core electrodes 13 so as to deposit the metal on them (precipitate them). In this embodiment, the plating material used for the deposition layers 15 is copper, so a copper sheet is used for the anode and the board 10 on which the core electrodes 13 are formed is used for the cathode. The conductive paths 16 for plating shown in FIGS. 3A and 3B are cut after the plating by forming holes 16a by drilling or laser. Further, when the copper foil used for the board 10 is thin, the conductive paths 16 can be masked in advance by a plating resist and removed by soft etching of a later step.

Note that the core electrodes 13 may also be electrolessly plated. Electroless plating uses a plating solution containing metal ions and a reducing agent to cause reduced metal ions to precipitate on the plated material. With this method, the metal ions have a good reach, so even inside surfaces of holes or inside surfaces of grooves of a board 10 having through holes or grooves can be plated. Further, there is no need for conductive paths for plating, there is no need for cutting the conductive paths after plating, and the work efficiency is therefore improved.

FIG. 1C shows the state where strip-shaped electrodes 12 having the deposition layers 15 are insulated by an insulator constituted by the coverlay film 18. The insulating layer 19 of the coverlay film 18 is for example comprised of an epoxy resin which is heated and vacuum pressed to be bonded integrally with the strip-shaped electrodes 12. The air contacting the strip-shaped electrodes 12 serves as an insulating layer. By using the coverlay film 18 to insulate from the surroundings, it is possible to supply a higher drive voltage and possible to increase the motor output in proportion to the square of the drive voltage.

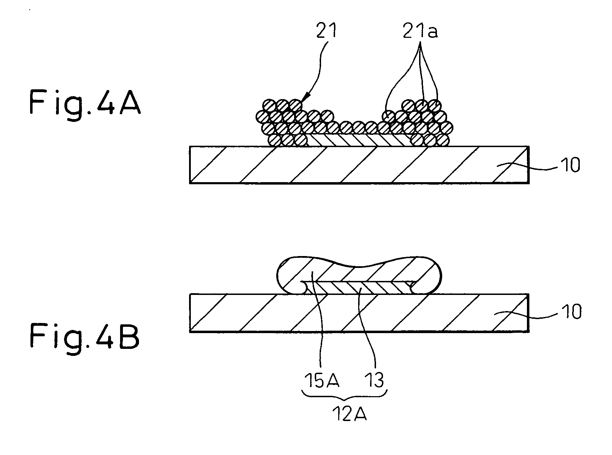

Next, a modification of the method of forming the deposition layers on the core electrodes will be explained based on FIGS. 4A and 4B. FIG. 4A shows the selective formation of deposition layers 15a by electrostatic coating on the core electrodes 13 patterned by photolithography. The coating material 21 used is a high resistivity binder containing conductive particles 21a of silver or carbon. After the electrostatic coating, as shown in FIG. 4B, this is heated to remove the binder. Conductivity is secured by metallization of the silver particles or concentration of the carbon. With this method as well, in the same way as with electroplating, the not shown conductive paths are cut after formation of the deposition layers 15A.

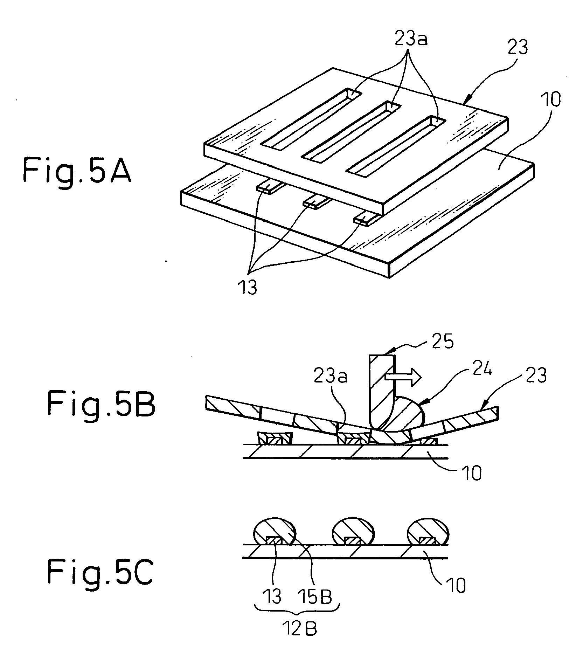

Further, next, another modification of the method of forming deposition layers on the core electrodes will be explained based on FIGS. 5A to 5C. This method uses screen printing to form deposition layers 15B on the core electrodes 13. Screen printing is performed using a screen 23 formed with predetermined printing patterns shown in FIG. 5A. This screen 23 is positioned over the board 10, then, as shown in FIG. 5B, solder paste 24 containing conductive particles is coated on the board through the holes 23a of the screen 23 from a moving squeegee 25. The solder paste 24 is then heated to a predetermined temperature to melt it and make it reflow. By reflow of the solder paste 24, the deposition layers 15B become smoothly round, the two sides of the strip-shaped electrodes 12 are built up outward, and field concentration can be avoided.

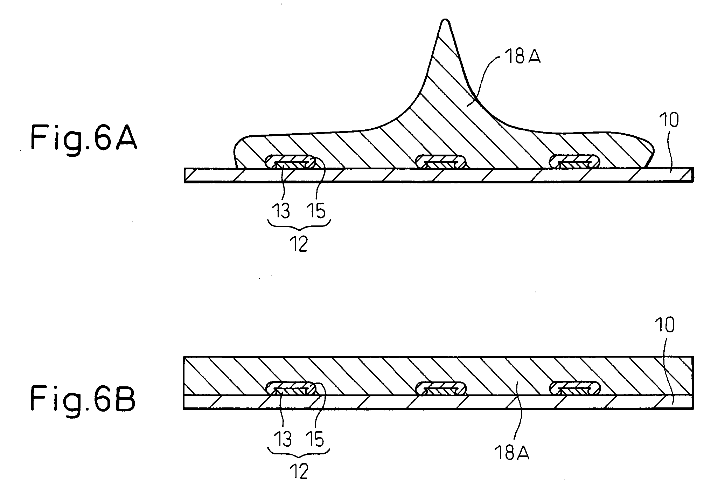

Next, a modification of a method of covering the strip-shaped electrodes by an insulator will be explained based on FIG. 6A, 6B. This method differs from the case where the strip-shaped electrodes 12 are covered by a coverlay film 18 on the point that the strip-shaped electrodes 12 are covered by a liquid insulator 18A. According to the method of this modification, as shown in FIG. 6A, the insulator 18A reaches under the parts of the deposition layers 15 overhanging at the two sides of the strip-shaped electrodes 12, whereby no voids remain any longer between the strip-shaped electrodes 12 and the insulator 18A. The liquid insulator 18A is, for example, heated in a mold while being deaerated under vacuum, so no voids remain any longer and the insulator solidifies in a flat shape (FIG. 6B).

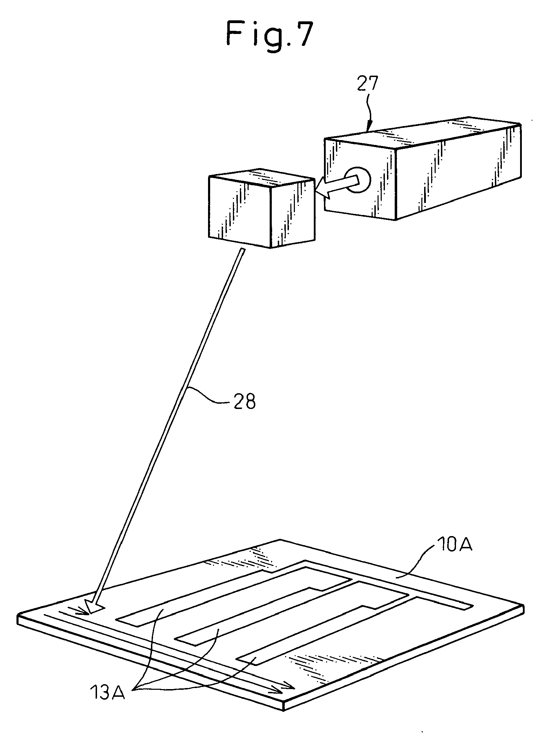

Next, a second embodiment of a method of production of electrodes for an electrostatic motor will be explained based on FIG. 7. This embodiment differs from the case of patterning by photolithography of the first embodiment on the point that a laser is used to pattern the plurality of core electrodes 13A on the board 10A. The step, after forming the core electrodes 13A, of forming deposition layers on the core electrodes 13A by plating or another means so as to form the strip-shaped electrodes is the same as in the first embodiment. Further, the insulation and protection of the strip-shaped electrodes by an insulator after forming the strip-shaped electrodes is the same as in the first embodiment.

This method uses a board 10A formed with thin copper foil by sputtering or electroless plating and fires a laser beam 28 from a laser device 27 on the copper foil to remove parts by the heat of the laser beam 28 and thereby pattern core electrodes 13A. With this method, since heat is used for patterning the core electrodes 13A, the board 10A used is an inorganic one made of ceramic etc. As the ceramic, a superior heat thermal shock alumina (Al₂O₃), zirconia (ZrO₂) , or silicon nitride (Si₃N₄) ceramic is suitable. As the conductor material formed on the board 10A, copper, zinc, or another base metal which can be easily removed by oxidation combustion may be used. Note that when patterning core electrodes by a silver mirror reaction etc. causing deposition of a conductor by a photochemical reaction, it is possible to use an ordinary board 10A.

According to this second embodiment, the core electrodes 13A are removed by non-etching means, so the core electrodes 13A are not formed with undercuts at their side edges. Therefore, the unblemished core electrodes 13A can be used as they are as strip-shaped electrodes. Further, treatment of the waste liquor after patterning of the core electrodes 13A is no longer necessary. In the same way as the first embodiment, if forming deposition layers on the outside surfaces of the core electrodes, the two sides of the strip-shaped electrodes become smoothly rounded, the surface areas of the electrodes increase, the drive voltage can be increased more, and the output of the electrostatic motor can be improved.

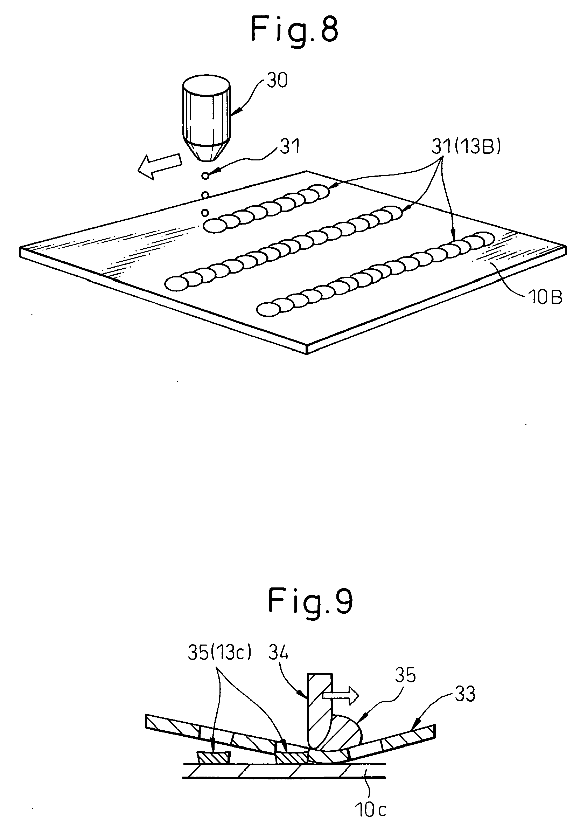

Next, a third embodiment of a method of production of electrodes for an electrostatic motor will be explained based on FIG. 8. This embodiment differs from the first embodiment on the point that ink jet printing is used to form the plurality of core electrodes 13B on the board 10B. The step, after forming the core electrodes 13B, of forming deposition layers on the core electrodes 13B by plating or another means so as to form the strip-shaped electrodes is the same as in the first embodiment. Further, the insulation and protection of the strip-shaped electrodes by an insulator after forming the strip-shaped electrodes is the same as in the first embodiment.

In this method, as the conductive ink 31, ink containing nanoconductive particles is used. For the nanoconductive particles, silver or carbon is used. The ink 31 is sprayed from a nozzle 30 to pattern the core electrodes 13B, then the core electrodes 13B are heated to remove the binder and metallize or concentrate the nanoconductive particles. Note that with ink jet printing, instead of conductive ink 31, it is also possible to print a catalyst material forming the core of electroless plating and form the core electrodes by electroless plating.

In this third embodiment as well, like the second embodiment, the core electrodes 13B are formed by non-etching means, so the core electrodes 13B are not formed with undercuts at their side edges. It is also possible to use unblemished core electrodes 13B as they are as strip-shaped electrodes. Further, the insulation and protection of the strip-shaped electrodes by an insulator after forming the strip-shaped electrodes is the same as in the first embodiment.

Next, a fourth embodiment of a method of production of electrodes for an electrostatic motor will be explained based on FIG. 9. This embodiment differs from the first embodiment on the point of using screen printing to form the plurality of core electrodes 13C on the board 10C. The step, after forming the core electrodes 13C, of forming deposition layers on the core electrodes 13C by plating or another means so as to form the strip-shaped electrodes is the same as in the first embodiment.

In this method, conductive ink 35 comprised of a dispersant in which silver, copper, carbon, or other conductive particles are included is used. The ink 35 is placed on the screen 33 and a spatula-shaped squeegee 34 is used to slide the ink 35 and drop it from the parts with no resist so as to print the board 10. After the core electrodes 13C are patterned, they are dried etc. to remove the dispersant so as to metallize or concentrate the conductive particles and obtain conductivity. With this method, it is possible to easily and relatively precisely print the core electrodes 13C.

In this fourth embodiment as well, like the second and third embodiments, the core electrodes 13C are formed by non-etching means, so the core electrodes 13C are not formed with undercuts at their side edges. It is also possible to use unblemished core electrodes 13C as they are as strip-shaped electrodes. Further, the insulation and protection of the strip-shaped electrodes by an insulator after forming the strip-shaped electrodes is the same as in the first embodiment.

Note that the present invention is not limited to the above embodiments and can be modified in various ways within a scope not departing from the framework of the present invention. For example, in the first to fourth embodiments, the explanation was given for an electrostatic motor having strip-shaped electrodes 12 at both the facing stator 5 and slider, but the invention can also be applied to an electrostatic motor having strip-shaped electrodes 12 at only one of the stator 5 and slider.

Above, the present invention was explained in relation to preferred embodiments, but a person skilled in the art will understand that it can be modified and changed in various ways without departing from the scope of the later explained claims.

## Claims

1. A method of production of electrodes for an electrostatic motor generating electrostatic force between a facing stator (5) and slider, **characterized in that** said method of production of electrodes for an electrostatic motor comprises the steps of forming core electrodes (13) on a board (10) of at least one of said stator (5) and said slider by patterning a conductive substance, and depositing a conductive substance on said core electrodes (13) so that a side edge becomes rounded.

2. A method of production of electrodes for an electrostatic motor as set forth in claim 1,
wherein any one of electroplating, electroless plating, electrostatic coating, or screen printing is used to deposit said conductive substance on said core electrodes (13).

3. A method of production of electrodes for an electrostatic motor as set forth in claim 1,
wherein said core electrodes (13) are patterned using non-etching means.

4. A method of production of electrodes for an electrostatic motor as set forth in claim 3,
wherein a board (10) covered by a conductive film in advance is used and the conductive film is lasered so as to pattern the core electrodes (13).

5. A method of production of electrodes for an electrostatic motor as set forth in claim 3,
wherein said core electrodes (13) are patterned by screen printing or ink jet printing using conductive ink.

6. Electrodes for an electrostatic motor generating an electrostatic force between a facing stator (5) and slider **characterized in that** said electrodes for an electrostatic motor comprises core electrodes patterned a the board (10) of at least one of said stator (5) and said slider, and a conductive substance deposited on said core electrodes (13) to form deposition layers so that a side edge becomes rounded.

7. Electrodes for an electrostatic motor as set forth in claim 6,
wherein said deposition layers are formed by any method selected from electroplating, electroless plating, electrostatic coating, and screen printing.

8. Electrodes for an electrostatic motor as set forth in claim 6,
wherein said core electrodes (13) are patterned using non-etching means.

9. An electrostatic motor, comprising:
a facing stator (5) and slider; and
a plurality of electrodes arranged at equal intervals on at least one of said stator (5) and said slider and supplied with voltage so as to generate electrostatic force between said stator (5) and said slider,
wherein said electrodes are electrodes set forth in claim 6.
